# DEMANDE DE BREVET EUROPEEN

(11) **EP 3 839 091 A1**
(43) Date de publication de la demande: **23.06.2021**
(21) Numéro de dépôt: 20213834.3
(22) Date de dépôt: 14.12.2020
(51) Int. Cl.: C23C 16/40, C23C 16/458, C23C 16/505, H01L 21/677

(54) **DISPOSITIF DE DEPOT CHIMIQUE EN PHASE VAPEUR ASSISTE PAR PLASMA À CAPACITE DE PRODUCTION AUGMENTEE**

(30) Priorité: 19.12.2019 FR 1914982
(71) Demandeur: Commissariat à l'énergie atomique et aux énergies alternatives, 75015 Paris (FR)
(72) Inventeur: MONNA, Rémi, 38054 GRENOBLE Cedex 09 (FR); VACHEZ, Alexandre, 38054 GRENOBLE Cedex 09 (FR)
(74) Mandataire: Brevalex

(57) **Abrégé**

Dispositif de dépôt chimique en phase vapeur assisté par plasma sur une pluralité de substrats comportant une enceinte, des moyens d'alimentation en gaz et des moyens d'évacuation connectés à l'enceinte, un porte-nacelle (6) logé dans l'enceinte et configuré pour entrer et être extrait par l'ouverture, des nacelles (4) configurées pour supporter des substrats, lesdites nacelles comportant une pluralité de plaques entre lesquelles sont logés les substrats, chaque nacelle (4) comportant des moyens de manutention configurés pour coopérer avec un dispositif de manutention extérieur. Le porte-nacelle (6) et les nacelles (4) sont configurés pour que les nacelles soient suspendues de manière amovible par rapport au porte-nacelle, que les substrats soient orientées verticalement une fois les nacelles suspendues au porte-substrat et que les nacelles soient disposées l'une au-dessus de l'autre.

## Description

### DOMAINE TECHNIQUE ET ÉTAT DE LA TECHNIQUE ANTÉRIEURE

La présente invention se rapporte à un dispositif de dépôt chimique en phase vapeur assisté par plasma à capacité de production augmentée.

Le dépôt chimique en phase vapeur assisté par plasma ou PECVD (pour Plasma-Enhanced Chemical Vapor Deposition en terminologie anglo-saxonne) est un procédé utilisé pour déposer des couches minces sur un substrat à partir d'un état gazeux.

Ce dépôt est par exemple mis en œuvre dans le domaine de la fabrication des cellules photovoltaïques pour le dépôt de couches diélectriques sur un substrat, par exemple en silicium.

Le procédé de dépôt chimique en phase vapeur assisté par plasma se déroule de la manière suivante. Des réactions chimiques ont lieu après la formation d'un plasma à partir de gaz. Par exemple, le plasma est créé à partir d'un ou plusieurs gaz et en leur appliquant une excitation par décharge électrique générée à partir de sources radiofréquences (40 kHz à 440 kHz).

Par exemple, une excitation par décharge capacitive est réalisée en appliquant un signal radiofréquence entre deux électrodes. Le gaz étant injecté par le haut du tube, des extinctions et allumages du plasma dans le temps permettent d'obtenir une bonne homogénéité du dépôt le long du tube. Les excitations à basse fréquence (40 kHz à 440 kHz) nécessitent plusieurs centaines de volts pour maintenir la décharge. La pression de travail est comprise entre 100 mTorrs et 2000 mTorrs.

Dans le cas de la fabrication des cellules photovoltaïques en silicium, le dépôt par plasma est utilisé pour réaliser les passivations des surfaces avant et arrière ainsi que les couches antireflets. Le nitrure de silicium (SiNₓ) est largement utilisé pour réaliser les couches antireflets déposées sur la face avant des cellules en utilisant un mélange de gaz silane (SiH₄) et ammoniac (NH₃). Un oxyde de silicium (SiOₓ) peut être déposé à partir de silane et de protoxyde d'azote (N₂O), généralement à des pressions allant de quelques centaines de millitorrs à quelques torrs.

Le dépôt PECVD est également très largement utilisé pour déposer des couches d'oxyde d'aluminium (AlOₓ) afin de passiver la face arrière des cellules photovoltaïques à structure PERC (Passivated Emitter and Rear Cell en terminologie anglo-saxonne).

Dans le cas d'une fabrication industrielle, on utilise par exemple une nacelle comportant une pluralité de plateaux empilés les uns sur les autres, par exemple de 30 à 100 plateaux, destinés à former des électrodes, les plateaux étant isolés électriquement les uns des autres par des entretoises. Chaque plateau forme un support pour un ou plusieurs substrats sur lesquels on souhaite effectuer le ou les dépôts.

La nacelle complète est reliée par deux câbles de polarités opposées au générateur radiofréquence.

Le dispositif de dépôt comporte une enceinte tubulaire ouverte au niveau de son extrémité supérieure et par laquelle est insérée la nacelle chargée des substrats dans l'enceinte. Les plateaux sont disposés à l'horizontal dans l'enceinte.

En général la nacelle est fixée à la porte de l'enceinte.

Le chargement des substrats dans la nacelle et leur déchargement sont réalisés de manière automatique par un robot.

Le déroulement d'un dépôt PECVD sur des substrats est le suivant :
- Les substrats sont chargés dans la nacelle.
- La nacelle est mise en place dans le tube qui est fermé par la porte qui porte la nacelle.
- Un plasma est formé à partir de gaz provoquant un dépôt sur les substrats.
- La nacelle est sortie du tube.
- Une étape de refroidissement des substrats est requise avant déchargement des substrats.

Ensuite la nacelle est à nouveau chargée en substrats en vue d'un nouveau dépôt PECVD.

On cherche à augmenter le nombre de substrats pouvant être traités simultanément dans une enceinte afin d'augmenter la capacité de production du dispositif.

### EXPOSÉ DE L'INVENTION

C'est par conséquent un but de la présente invention d'offrir un dispositif de dépôt chimique en phase vapeur assisté par plasma présentant une capacité de production augmentée.

Le but énoncé ci-dessus est atteint par un dispositif de dépôt chimique en phase vapeur assisté par plasma comportant au moins une enceinte de dépôt chimique en phase vapeur assisté par plasma d'axe vertical comportant une ouverture à son extrémité longitudinale supérieure, une porte, un porte-nacelle, au moins deux nacelles comportant chacune une pluralité de plateaux isolés électriquement les uns des autres, lesdits plateaux et le support de nacelle étant configurés pour que les nacelles soient disposées l'une au-dessus de l'autre lorsqu'elles sont suspendues au porte-nacelle et de sorte à orienter les plateaux verticalement lorsqu'il sont supportés par le porte-nacelle. En outre le porte-nacelle est configuré pour connecter les nacelles à un générateur électrique.

Les inventeurs ont constaté que le fait de réaliser des nacelles dont les plateaux sont à la vertical, il était avantageusement possible de placer des substrats sur les deux faces des plateaux, et que le fait de disposer avantageusement les nacelles les unes aux dessus, permettait à l'enceinte de contenir un nombre sensiblement plus important de substrats pouvant être traités simultanément.

De manière particulièrement avantageuse, les nacelles sont simplement supportées par le porte-nacelle, elles peuvent alors être retirées et mises en place très rapidement. Ainsi le chargement et le déchargement des substrats des plateaux peuvent avoir lieu dans une zone distincte de la zone de dépôt et en temps masqué.

De même le nettoyage des plateaux peut avoir lieu dans une zone de nettoyage et permettre simultanément l'utilisation de l'enceinte.

La présente invention a alors pour objet un dispositif de dépôt chimique en phase vapeur assisté par plasma sur une pluralité de substrats comportant :
- une enceinte configurée pour réaliser un dépôt chimique en phase vapeur assisté par plasma, ladite enceinte s'étendant le long d'une direction longitudinale orientée verticalement et étant munie d'une ouverture au niveau d'une extrémité longitudinale supérieure et une porte obturant ladite ouverture,
- des moyens d'alimentation en gaz et des moyens d'évacuation connectés à l'enceinte,
- un porte-nacelle logé dans l'enceinte et configuré pour entrer et être extrait par l'ouverture,
- au moins deux nacelles configurées pour supporter des substrats sur lesquelles les dépôts sont à effectuer, lesdites nacelles comportant une pluralité de plaques entre lesquelles sont destinées à être logés les substrats, chaque nacelle comportant des moyens de manutention configurés pour coopérer avec un dispositif de manutention extérieur,
- le porte-nacelle et les nacelles étant configurés pour que les nacelles soient suspendues de manière amovible par rapport au porte-nacelle, que les substrats soient orientées verticalement une fois les nacelles suspendues au porte-substrat et que les nacelles soient disposées l'une au-dessus de l'autre.
- des moyens de connexion à un générateur électrique.

Par exemple, le porte-nacelle comporte deux paires de montants et au moins deux paires de traverses fixées aux montants, les traverses d'une paire étant parallèles entre elles et étant disposées dans un même plan sensiblement horizontal, et les nacelles comportent des pattes coopérant avec les traverses de sorte à suspendre les nacelles au porte-nacelle.

De manière très avantageuse, les montants et les traverses sont en matériau conducteur électrique et sont destinés à être connectés au générateur électrique et assurent la polarisation des plaques des nacelles, et les pattes sont issues des plaques et forment des pattes de connexion en contact électrique avec les traverses.

Par exemple, deux plaques successives d'une nacelle sont à des polarités opposées, une traverse d'une paire de traverses est à une polarité et l'autre traverse de ladite paire de traverses est à la polarité opposée, et chaque plaque comporte une patte de connexion en contact avec la traverse ayant la polarité à laquelle ladite plaque est destinée à être polarisée.

Selon un exemple de réalisation, la nacelle comporte sur une face latérale des pattes de connexion à une traverse d'une paire de traverses, et sur une autre face latérale opposée des pattes de connexion à l'autre traverse de ladite paire de traverses.

Selon une caractéristique avantageuse, des éléments conducteurs électriques sont disposés entre deux pattes de connexion de deux plaques destinées à être à la même polarité.

Les pattes de connexion et les éléments conducteurs électriques sont avantageusement conformés pour présenter une surface de contact importante avec les traverses.

De préférence, les plaques comportent sur au moins une de leurs faces au moins un jeu de picots disposé pour supporter un substrat en position verticale et assurer le contact électrique entre le substrat et la plaque.

Les nacelles peuvent comporter des plaques d'extrémité et des plaques intérieures comprenant n fenêtres traversantes, n étant un entier supérieur ou égal à 1, chaque fenêtre traversantes ayant la forme d'un substrat. Par exemple, chaque jeu de picots entoure une fenêtre.

De préférence, les moyens de manutention des nacelles comportent des pattes de manutention configurées pour coopérer avec un dispositif de manutention pour la mise en place et le retrait des nacelles du porte-nacelle. Par exemple, les pattes de manutention s'étendent des bords latéraux de chaque nacelle.

Le dispositif de dépôt comporte avantageusement un robot assurant un déplacement vertical du porte-nacelle.

Le porte-nacelle peut être fixé à la porte.

La présente invention a également pour objet un dispositif de manutention destiné à mettre en place et à retirer les nacelles du dispositif de dépôt selon l'invention, comportant au moins deux paires de bras superposés verticalement, les bras de chaque paire étant configurés pour venir se positionner sous les pattes de manutention, les bras étant mobiles verticalement et horizontalement en éloignement et en rapprochement du porte-nacelle.

Avantageusement, les bras sont mobiles en rotation autour d'un axe vertical.

La présente invention a également pour objet une installation de dépôt chimique en phase vapeur assisté par plasma sur une pluralité de substrats comportant le dispositif de dépôt selon l'une des revendications, un générateur électrique connecté aux nacelles et un dispositif de manutention selon l'invention.

L'installation peut comporter une zone de chargement/déchargement des substrats des nacelles, une zone de refroidissement, et la zone de chargement/déchargement, la zone de refroidissement et le dispositif de dépôt sont disposés autour de l'axe vertical du dispositif de manutention.

La zone de chargement/déchargement et/ou la zone de refroidissement comporte(nt) avantageusement un support de nacelles comportant des traverses horizontales destinées à coopérer avec les pattes de connexion.

### BRÈVE DESCRIPTION DES DESSINS

La présente invention sera mieux comprise sur la base de la description qui va suivre et des dessins en annexe sur lesquels :
La figure 1 est une représentation schématique en perspective d'un dispositif de dépôt PECVD selon un exemple de réalisation dans un état chargé,
La figure 2 est une représentation schématique du dispositif de la figure 1 dans un état déchargé.
La figure 3 est une vue en perspective d'un exemple de nacelle adapté à la mise en place dans le porte-nacelle du dispositif de la figure 1.
La figure 4 est une vue de face de la nacelle de la figure 3, les traverses du porte-nacelle et les bras du dispositif de manutention étant représentés.
La figure 5 est une vue en coupe selon le plan A-A de la nacelle de la figure 3, la nacelle ne comportant pas de substrats.
La figure 6 est une vue en coupe selon le plan A-A de la nacelle de la figure 3, la nacelle comportant des substrats.
Les figures 7A, 7B et 7C sont des représentations schématiques de différentes phases de déchargement des nacelles du dispositif de la figure 1.
La figure 8 est une représentation schématique d'une installation de dépôt PECVD selon un exemple de réalisation.

### EXPOSÉ DÉTAILLÉ DE MODES DE RÉALISATION PARTICULIERS

Dans la suite de la description, « dépôt chimique en phase vapeur assisté par plasma » sera désigné par PECVD.

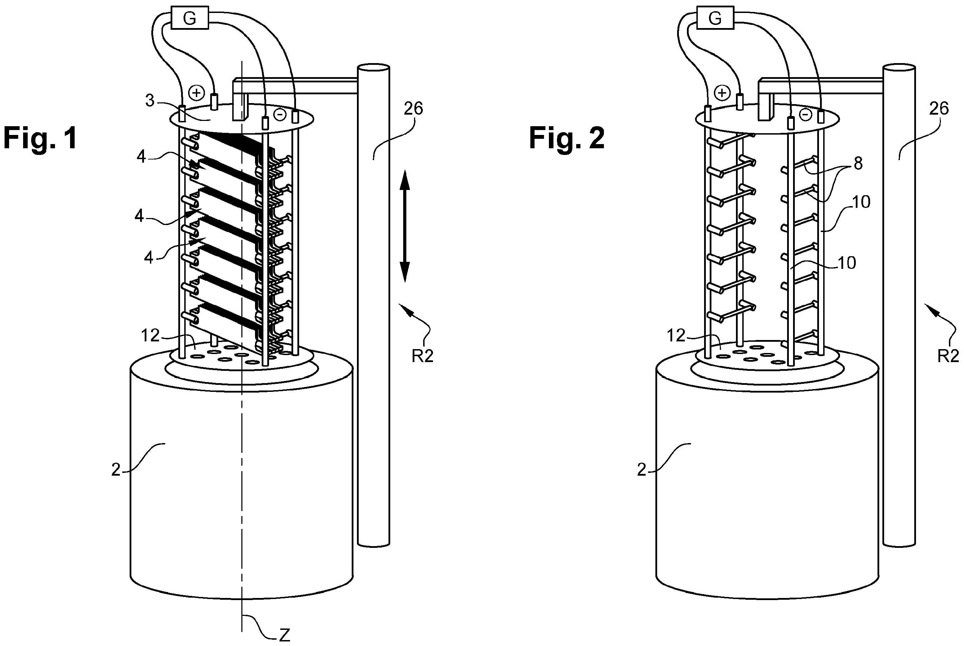

Sur les figures 1 et 2, on peut voir représenté schématiquement un exemple de dispositif de dépôt PECVD comportant une enceinte 2 de dépôt PECVD, de forme cylindrique de révolution d'axe vertical Z, munie d'une ouverture à son extrémité longitudinale supérieure pour la mise en place/ le retrait des nacelles 4 à l'intérieur de l'enceinte. Une porte 3 obture de manière étanche l'ouverture. Des tuyaux d'alimentation et d'évacuation de gaz et un câblage électrique pour polariser les plateaux sont prévus (non représentés). De manière avantageuse, les tuyaux d'alimentation et d'évacuation de gaz sont connectés à l'enceinte. Avantageusement la connexion électrique entre la nacelle et le câblage électrique s'effectue à travers le couvercle.

Le dispositif comporte également un porte-nacelle 6 configuré pour porter plusieurs nacelles 4.

Dans l'exemple représenté et de manière non limitative, le porte-nacelle 6 est solidaire de la porte 3.

Le porte-nacelle 6 comportent des traverses 8 horizontales fixées à des montants 10 verticaux. Dans l'exemple représenté, les montants 10 s'étendent entre la porte 3 et un fond de maintien 12. Les montants sont isolés électriquement de la porte et du fond de maintien. Le fond de maintien a de préférence une épaisseur fine, par exemple comprise entre 3mm et 7 mm afin de réduire la masse thermique du porte-nacelle. De manière avantageuse, le fond de maintien comporte des trous facilitant la circulation des gaz lors du dépôt. Chaque traverse est en forme de U de sorte qu'elle comporte une partie centrale écartée du plan contenant les deux montants à laquelle elle est fixée, et toutes les traverses ont leur partie centrale dans l'espace défini par les quatre montants, ce qui permet l'insertion et le retrait des nacelles.

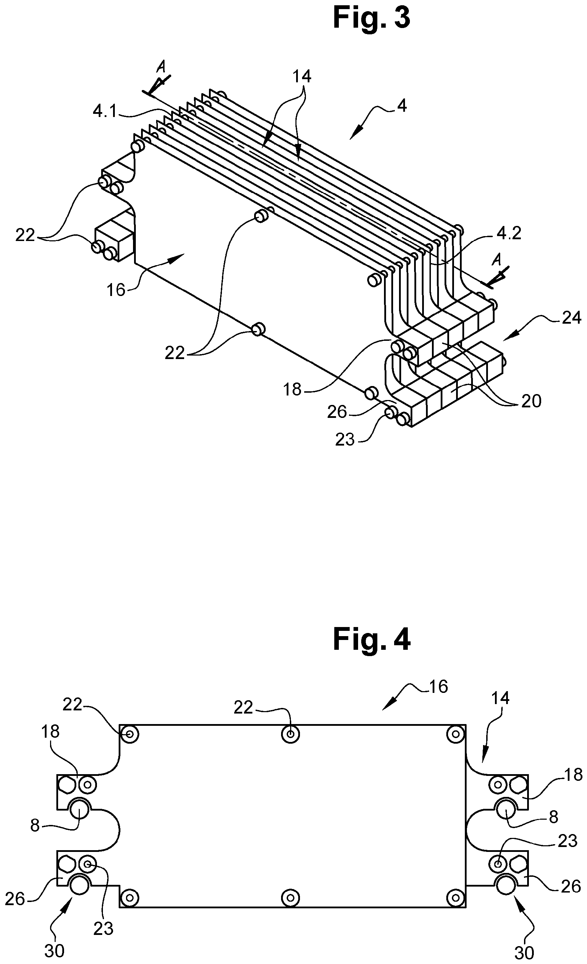

Sur les figures 3 à 6, on peut voir représenté un exemple de nacelle et les éléments qui la composent. La nacelle comporte une pluralité de plaques intérieures 14 entre lesquelles sont destinés à être logés des substrats S sur lesquels un dépôt PECVD doit avoir lieu. Chaque nacelle comporte deux plaques d'extrémité 16 pleines fermant la nacelle à ses deux extrémités. Les plaques d'extrémité comportent des évidements, par exemple d'une profondeur de 0,5 mm environ aux emplacements des substrats.

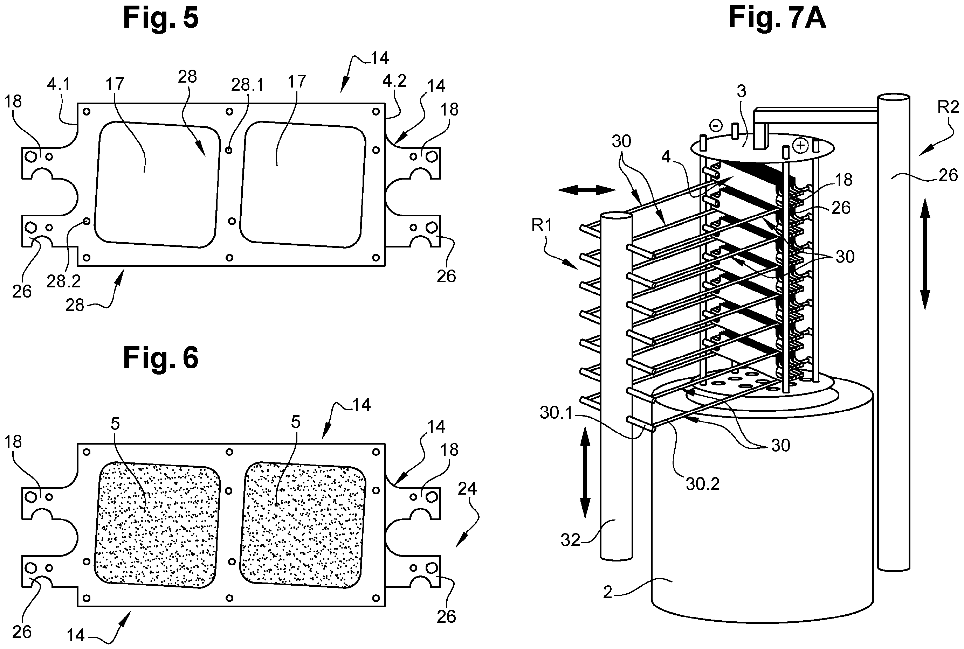

Sur les figures 5 et 6, on peut voir un exemple de plaque intérieure 14 comportant deux fenêtres traversantes 19 en regard desquelles au moins un substrat est destiné à être disposé. La mise en œuvre de fenêtre traversantes permet de réduire encore la masse thermique de la nacelle graphite
Les plaques d'extrémité 16 (figure 4) et les plaques intérieures 14 comportent des moyens destinés à coopérer avec les traverses 8 de sorte à assurer le support par les traverses 8 et l'alimentation électrique des plaques 14 et 16.

Les plaques intérieures 14 et d'extrémité 16 sont conductrices électriques, de préférence en graphite, et sont destinées à former des électrodes.

Deux plaques successives d'une nacelle sont reliées à des bornes polarités opposées du générateur radiofréquence (G), de sorte à créer un champ électrique et générer un plasma entre les substrats portés par les plaques.

Afin d'appliquer ces polarités opposées à deux plaques successives de l'empilement, on utilise avantageusement des traverses 8 et des montants 10 en matériau conducteur électrique, de préférence en cuivre. Une première paire de montants 10 et les traverses 8 s'étendant entre la première paire de montants sont à une polarité, positive dans l'exemple représenté, et une deuxième paire de montants 10 et les traverses 8 s'étendant entre la deuxième paire de montants sont à une polarité opposée, la polarité négative dans l'exemple représenté.

Les plaques intérieures 14 et d'extrémité 16 comportent des pattes de connexion 18 s'étendant latéralement et destinées à venir en appui sur la partie supérieure des traverses de sorte à assurer un support vertical pour la nacelle.

Les plaques destinées à être reliées à la première polarité, comportent chacune une patte de connexion 18 s'étendant latéralement vers l'extérieur d'un même premier côté 4.1 de la nacelle, et les plaques destinées à être reliées à la deuxième polarité, comportent chacune une patte de connexion 18 s'étendant latéralement vers l'extérieur d'un même deuxième côté 4.2 de la nacelle.

De préférence, les plaques destinées à être reliées à la même polarité sont reliées par des éléments conducteurs électriques 20 par exemple en graphite. Les éléments sont disposés entre les pattes de connexion successives et assurent une grande surface de connexion électrique entre les traverses 8 et la nacelle.

De préférence, les pattes de connexion 18 et les éléments conducteurs électriques comportent un évidement incurvé formant assise pour recevoir les traverses.

Les plaques sont juxtaposées et séparées par des entretoises isolantes électriques (non visibles), par exemple en alumine.

Les plaques sont maintenues serrées ensemble par des vis 22 en matériau isolant électrique évitant une connexion entre toutes les plaques.

A titre d'exemple, les plaques intérieures et d'extrémité ont une épaisseur entre 1,5 mm et 2 mm et la distance entre deux plaques est comprise entre 8 mm et 12 mm.

D'autres formes de traverses et d'évidement dans les pattes sont envisageables sans sortie du cadre de la présente invention, par exemple des traverses à section losangique et des évidements de forme triangulaire.

Chaque nacelle comporte également des moyens de manutention 24 des nacelles pour permettre son retrait du porte-nacelle et sa mise en place sur le porte-nacelle.

Les moyens de manutention 24, dans l'exemple représenté, comportent des pattes de manutention 26 similaires aux pattes de connexion 18 et s'étendant également latéralement d'un bord de chaque plaque.

Dans cet exemple, les pattes de manutention 26 s'étendent sensiblement parallèlement à la patte de connexion 18 et du même côté de la plaque et sont disposées sous les pattes de connexion 18. En variante, les pattes de manutention 26 sont situées au-dessus des pattes de connexion 18.

Avantageusement les pattes de manutention 26 comportent également un évidement de forme incurvée destiné à coopérer avec un dispositif de manutention qui sera décrit ci-dessous.

Les pattes de manutention 26 ne sont pas destinées à assurer une connexion aux bornes du générateur radiofréquence pendant la phase de dépôt.

En variante, chaque plaque peut comporter une patte de connexion 18 s'étendant d'un côté de la plaque, et une patte de manutention 26 s'étendant d'un autre côté de la plaque. En variante, on peut envisager que les pattes de manutention soient disposées sur le haut des plaques.

De préférence les éléments conducteurs électriques sont disposés à la fois entre les pattes de connexion 18 et entre les pattes de manutention 26 et des vis isolantes électriques 23 traversent les pattes 18 et 26 et les éléments conducteurs électriques 20. La disposition des éléments conducteurs électriques 20 entre les pattes de manutention assurent une plus grande rigidité de la nacelle.

Nous allons décrire en détail les plaques intérieures. Dans l'exemple représenté sur la figure 5, les plaques intérieures 14 comportent des fenêtres traversantes 19, deux dans l'exemple représenté, destinées à être recouvertes par les substrats S. La présence de fenêtres traversantes permet de réduire l'impédance de la plaque, ce qui, à puissance équivalente, permet d'augmenter la vitesse de dépôt et de chauffer plus rapidement l'électrode. Le temps de cycle peut alors être réduit. Les substrats forment alors eux-mêmes des électrodes. En outre, la masse thermique de chaque plaque est également réduite, ce qui permet de diminuer le temps de mise en température de la nacelle et de refroidissement de la nacelle.

Les fenêtres traversantes 19 ont une forme correspondant à la forme extérieure des substrats S. Dans l'exemple représenté, les fenêtres traversantes 19 et les substrats S sont carrés avec les quatre coins coupés, cette forme est désignée « pseudo-square ».

En variante encore, les substrats sont en forme de disque et les fenêtres traversantes sont circulaires.

De préférence, les formes et les dimensions des fenêtres traversantes sont telles que les substrats les recouvrent complétement.

Les fenêtres traversantes et les évidements des plaques d'extrémité sont bordés par des picots 28, s'étendant perpendiculairement au plan de la plaque et destinés à entrer en contact avec les bords des substrats, à supporter ceux-ci et à assurer la conduction électrique. Il est donc préférable que l'on s'assure que les substrats sont bien en contact avec les picots.

De préférence, chaque fenêtre traversante et chaque évidement est bordé de trois picots pour assurer un contact des bords du substrat avec tous les picots. Avantageusement, deux picots 28.1 assurent la tenue du substrat et un picot assure l'orientation du substrat dans la nacelle.

De manière avantageuse, les fenêtres traversantes et les évidements sont inclinés, i.e. dans l'exemple de fenêtres et d'évidements carrés, une médiatrice d'un côté de la fenêtre et une médiatrice d'un évidement sont inclinées par rapport à la direction verticale, les picots suivant l'inclinaison de sorte que lors de la mise en place des substrats, ceux-ci se mettent automatiquement en place contre les trois pions. Dans l'exemple représenté, deux picots bordent un angle inférieur d'un évidement ou d'une fenêtre, et un pion est situé à l'angle supérieur opposé.

Les picots sont avantageusement coniques, permettant l'utilisation des plaques pour différentes tailles de substrat.

De préférence, des picots s'étendent des deux faces de chaque plaque intérieure permettant une mise en place de substrats sur les deux faces de chaque plaque intérieure augmentant le nombre de substrats par nacelle.

Dans l'exemple représenté, chaque plaque peut porter deux substrats par face. En variante, elle peut porter un substrat par plaque ou plus de deux, par exemple quatre substrats répartis en carré.

Les nacelles sont supportées par le porte-nacelle les uns au-dessus des autres, et chaque nacelle est connectée individuellement, contrairement aux dispositifs de l'état de la technique dans lesquels une seule nacelle de grande taille est mise en œuvre, la connexion au générateur ayant lieu sur une extrémité de la nacelle.

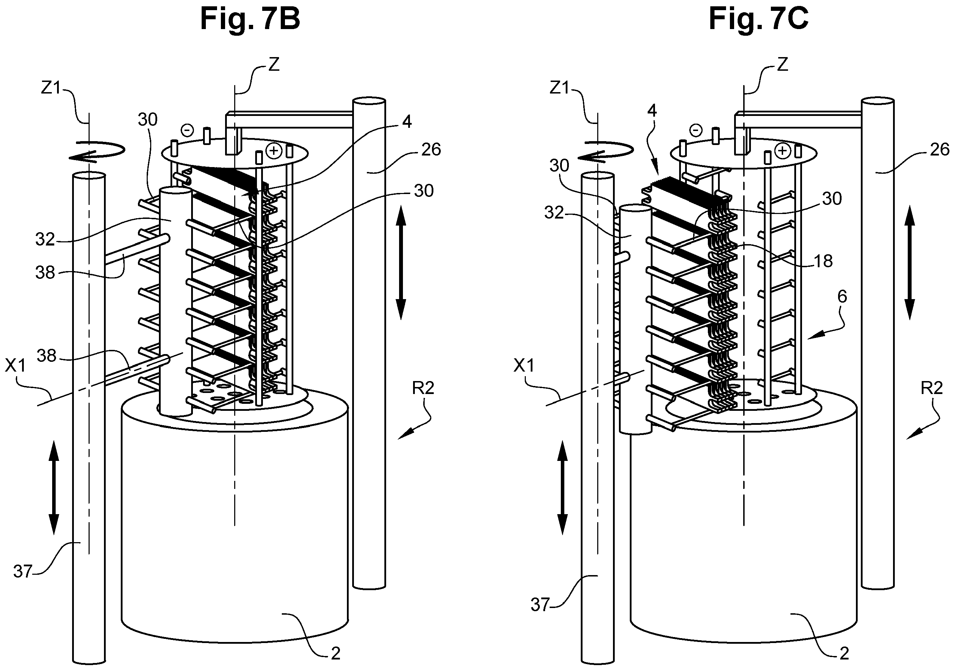

Nous allons maintenant décrire un exemple de dispositif de manutention permettant de charger et décharger les nacelles sur et du porte-nacelle, représenté sur les figures 7A à 7C.

Le dispositif de manutention ou robot R1 comporte des paires de bras 30 destinées à se loger sous les pattes de manutention 26 d'une nacelle, à venir en contact avec celles-ci pour soulever la nacelle et écarter les pattes de connexion 18 des traverses 8.

Les bras 30 comportent une portion 30.1 fixée à un châssis 32 et une portion 30.2 destinée à se glisser sous les pattes de manutention 26.

Le dispositif comporte avantageusement autant de paires de bras 30 que de nacelles pouvant être supportées par le porte-nacelle, permettant ainsi de charger toutes les nacelles sur le porte-nacelle ou de décharger toutes les nacelles simultanément En variante, le dispositif de manutention peut comporter moins de paires de bras que de nacelles portées par le porte-nacelle, voir une seule paire de bras chargeant et déchargeant chaque nacelle individuellement.

Chaque paire de bras 30 est fixée au châssis 32. Dans l'exemple représenté, il comporte un montant central orienté verticalement et les deux portions 30.1, 30.2 sont orientées à angle droit.

Le châssis est fixé à un arbre 37 mobile en rotation autour d'un axe vertical Z1 et assurant à la fois le déplacement vertical du châssis le long de l'axe Z1, le déplacement en rotation autour de l'axe Z1 et le déplacement le long d'un axe X1 orthogonal à l'axe Z1, afin de permettre d'extraire les nacelles du porte-nacelle ou de les charger dans le porte-nacelle. Dans l'exemple représenté, le robot R1 comporte deux bras télescopiques 38 entre l'arbre 37 et le châssis. En variante, on peut envisager que le robot R2 soit mobile en translation, par exemple qu'il comporte des roues permettant de transporter les nacelles vers une zone éloignée de l'enceinte ou les transporter d'un endroit éloigné.

Sur les figures 1 et 2, on peut voir également représenté un robot R2 assurant le déplacement du porte-nacelle. Le robot R2 comporte un mât télescopique 36 assurant un déplacement vertical du porte-nacelle entre une position à l'intérieur de l'enceinte pour la phase de dépôt, et une position à l'extérieur de l'enceinte pour charger et décharger les nacelles.

De manière avantageuse, l'enceinte, la zone de chargement/déchargement et la zone de refroidissement sont réparties angulairement autour de l'axe Z1. Ainsi le robot de manutention R2 a accès à toutes les zones.

Le dispositif de dépôt peut comporter plusieurs enceintes, par exemple quatre enceintes fonctionnant simultanément, dans ce cas on peut envisager quatre robots de manutention R1 disposés autour de quatre enceintes.

Les plaques de nacelles décrites comportent des fenêtres. Néanmoins, des nacelles comportant des évidements ou des plaques pleines ne sortent pas du cadre de la présente invention. De préférence, les plaques comportent au moins trois picots par substrat disposés de sorte que le substrat se met en place directement contre les picots.

Les plaques telles que décrites comportant une patte de connexion 18 et éventuellement une patte de manutention 26 sur une face latérale présentent l'avantage de pouvoir utiliser des plaques identiques pour tout l'empilement. En effet il suffit, lors du chargement d'une nacelle, d'orienter les plaques pour placer alternativement la patte de connexion à gauche puis à droite dans la représentation de la figure 4. La fabrication des plaques est simplifiée, ainsi que la gestion des stocks et le chargement de nacelles.

Dans l'exemple représenté, la connexion électrique des nacelles se fait automatiquement via le contact entre les pattes de connexion 18 et les traverses. En variante, on peut envisager que les pattes 18 ne soient que des pattes de suspension, et que la connexion électrique de chaque nacelle se fasse par des moyens séparés, par exemple des moyens filaires connectés individuellement à chaque nacelle.

Les nacelles sont de préférence nettoyées « ex-situ » par trempage de celles-ci de façon complète et non démontées dans un bain de nettoyage. Ce nettoyage «ex-situ» permet de ne pas immobiliser l'enceinte de dépôt pour effectuer le nettoyage par plasma C₂F₆/O₂ ou NF₃/O₂ dans l'enceinte. Ce nettoyage « ex-situ » permet d'augmenter considérablement le temps d'utilisation du dispositif de dépôt.

Le porte-nacelle et la porte peuvent être facilement séparés du robot R2 afin d'effectuer leur nettoyage complet.

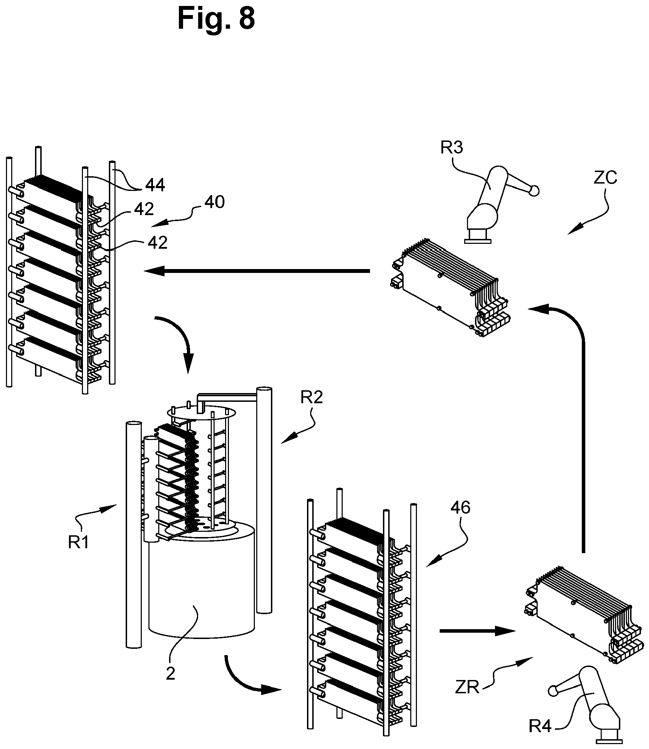

Le fonctionnement de l'installation de dépôt va maintenant être décrit. Sur la figure 8, on peut voir une représentation schématique d'une installation selon un exemple de réalisation.

Chaque nacelle est chargée avec des substrats S, dans la zone de chargement ZC au moyen d'un robot R3. Les plaques sont assemblées formant des nacelles et les substrats sont mis en place dans les nacelles de part et d'autre de chaque plaque intérieure

Il est préparé autant de nacelles que peut en accueillir le porte-nacelle, sept dans l'exemple représenté. Les nacelles sont mises en place sur un support de nacelles 40 de structure similaire à celle du porte-nacelle, et sur lequel le robot R1 va déposer les nacelles. Il effectue la même opération que pour le chargement des nacelles dans le porte-nacelle. Les nacelles reposent alors par les pattes de connexion 18 sur des traverses 42 montés sur des montants 44.

Ensuite, chaque nacelle est mise en place sur une paire de bras 30 du robot de manutention R1. Pour cela, on fait reposer les pattes de manutention 26 sur les bras 30.

Lorsque toutes les nacelles ont été disposées dans le robot de manutention R2, le robot de manutention R2 est actionné pour venir placer les nacelles sur les traverses 8 sur porte-nacelle. Le châssis est pivoté pour placer les bras 30 parallèles aux traverses, les bras télescopiques sont déployés pour loger les nacelles à l'intérieur du porte- nacelle. Les bras 30 sont positionnés suffisamment hauts pour que les pattes de connexion 18 soient au-dessus des traverses. Ensuite le châssis est abaissé permettant aux pattes de connexion 18 de venir reposer sur les traverses 8, les bras 30 s'écartant alors des pattes de manutention 26. Les bras télescopiques sont rétractés et les bras 30 s'éloignent du porte-nacelle. Le robot R2 peut alors abaisser le porte-nacelle chargé dans l'enceinte (figure 1). La phase de dépôt par PECVD sur les substrats peut avoir lieu. Par exemple, l'intérieur de l'enceinte est alimenté en gaz, par exemple en un mélange de silane (SiH₄) et ammoniac (NH₃) pour réaliser une couche de nitrure de silicium.

Lorsque la phase de dépôt est terminée, l'enceinte est ouverte. Le robot R2 extrait le porte-nacelle et les nacelles de l'enceinte en déplaçant verticalement vers le haut le porte-nacelle.

Le robot R1 est commandé de sorte à venir placer les bras 30 entre les montants 10 du porte-nacelle sous les pattes de manutention 26. Les bras 30 sont déplacés verticalement vers le haut, chaque paire de bras 30 venant en appui contre les pattes de manutention 26 d'une nacelle jusqu'à soulever toutes les nacelles simultanément et à écarter les pattes de connexion 18 des traverses.

Les bras télescopiques sont ensuite rétractés pour extraire les nacelles de l'intérieur du porte-nacelle (figure 7C). L'arbre 37 du robot de manutention R1 est ensuite pivoté autour de l'axe Z1 pour amener les nacelles dans une zone de refroidissement qui se trouve par exemple dans une zone autour de l'axe Z1 et atteignable directement par le robot R1. Les nacelles sont déchargées dans la zone de refroidissement. Par exemple, la zone de refroidissement ZR comporte un support de nacelles 46 identique ou similaire au support de nacelles 40.

Les substrats sont retirés des nacelles par un robot R4.

L'enceinte peut être rechargée directement avec des nacelles chargées pour une nouvelle phase de dépôt.

A titre d'exemple, chaque nacelle peut accueillir 100 substrats silicium de taille de 156,75 mm x 156,75 mm ou 161,75 mm x 161,75 mm ou de diamètre 210 mm. Cette capacité d'accueil est avantageusement identique à celle des paniers de traitement chimique des substrats, par exemple un dépôt de nitrure de silicium après dépôt a lieu, pour cela les substrats sont disposés dans des cassettes d'une capacité de 100 substrats, ce qui permet de simplifier les opérations de transfert de nacelle à panier.

Dans l'exemple représenté, la capacité totale d'un porte-nacelle est de 700 substrats de silicium par enceinte. Dans le cas d'un dispositif de dépôt à quatre enceinte, la capacité de production comprise entre 5600 et 4800 wafers/heure pour un temps de cycle du procédé de dépôt compris entre 30 à 35 min respectivement, ce qui correspond aux capacités de production des équipements actuels.

Le temps de chargement /déchargement des 7 nacelles est compris entre 15 et 45 secondes, ce qui limite le temps pendant lequel l'enceinte PECVD est ouverte et n'est pas utilisée.

## Revendications

1. Dispositif de dépôt chimique en phase vapeur assisté par plasma sur une pluralité de substrats comportant :
- une enceinte (2) configurée pour réaliser un dépôt chimique en phase vapeur assisté par plasma, ladite enceinte s'étendant le long d'une direction longitudinale orientée verticalement et étant munie d'une ouverture au niveau d'une extrémité longitudinale supérieure et une porte obturant ladite ouverture,
- des moyens d'alimentation en gaz et des moyens d'évacuation connectés à l'enceinte,
- un porte-nacelle (6) logé dans l'enceinte et configuré pour entrer et être extrait par l'ouverture,
- au moins deux nacelles (4) configurées pour supporter des substrats (S) sur lesquelles les dépôts sont à effectuer, lesdites nacelles (4) comportant une pluralité de plaques entre lesquelles sont destinées à être logés les substrats (S), chaque nacelle (4) comportant des moyens de manutention configurés pour coopérer avec un dispositif de manutention extérieur,
- le porte-nacelle (6) et les nacelles (4) étant configurés pour que les nacelles (4) soient suspendues de manière amovible par rapport au porte-nacelle (6), que les substrats (S) soient orientées verticalement une fois les nacelles (4) suspendues au porte-substrat (6) et que les nacelles (4) soient disposées l'une au-dessus de l'autre,
- des moyens de connexion à un générateur électrique (G).

2. Dispositif de dépôt selon la revendication 1, dans lequel le porte-nacelle (6) comporte deux paires de montants (10) et au moins deux paires de traverses (8) fixées aux montants (10), les traverses (8) d'une paire étant parallèles entre elles et étant disposées dans un même plan sensiblement horizontal et dans lequel les nacelles comportent des pattes coopérant avec les traverses de sorte à suspendre les nacelles (4) au porte-nacelle (6).

3. Dispositif de dépôt selon la revendication 2, dans lequel les montants (10) et les traverses (8) sont en matériau conducteur électrique et sont destinés à être connectés au générateur électrique et assurent la polarisation des plaques des nacelles (4), et dans lequel les pattes sont issues des plaques et forment des pattes de connexion (18) en contact électrique avec les traverses (8).

4. Dispositif de dépôt selon la revendication 3, dans lequel dans une nacelle (4) deux plaques successives sont à des polarités opposées, dans lequel une traverse (8) d'une paire de traverses est à une polarité et l'autre traverse (8) de ladite paire de traverses est à la polarité opposée, et dans lequel chaque plaque comporte une patte de connexion (18) en contact avec la traverse (8) ayant la polarité à laquelle ladite plaque est destinée à être polarisée.

5. Dispositif de dépôt selon la revendication 4, dans lequel la nacelle comporte sur une face latérale des pattes de connexion (18) à une traverse (8) d'une paire de traverses, et sur une autre face latérale opposée des pattes de connexion (18) à l'autre traverse (8) de ladite paire de traverses, des éléments conducteurs électriques (20) étant avantageusement disposés entre deux pattes de connexion (18) de deux plaques destinées à être à la même polarité.

6. Dispositif de dépôt selon l'une des revendications 1 à 5, dans lequel les plaques comportent sur au moins une de leurs faces au moins un jeu de picots disposé pour supporter un substrat en position verticale et assurer le contact électrique entre le substrat et la plaque.

7. Dispositif de dépôt selon l'une des revendications 1 à 6, dans lequel les nacelles comportent des plaques d'extrémité et des plaques intérieures comprenant n fenêtres traversantes, n étant un entier supérieur ou égal à 1, chaque fenêtre traversantes ayant la forme d'un substrat.

8. Dispositif de dépôt selon les revendications 6 et 7, dans lequel chaque jeu de picots entoure une fenêtre traversante.

9. Dispositif de dépôt selon l'une des revendications 1 à 8 en combinaison avec la revendication 2, dans lequel les moyens de manutention des nacelles comportent des pattes de manutention (26) configurées pour coopérer avec un dispositif de manutention (R1) pour la mise en place et le retrait des nacelles du porte-nacelle, lesdites pattes de manutention (26) s'étendant avantageusement à partir des bords latéraux de chaque nacelle.

10. Dispositif de dépôt selon l'une des revendications 1 à 9, comportant un robot (R2) assurant un déplacement vertical du porte-nacelle, ledit porte-nacelle étant avantageusement fixé à la porte (3).

11. Dispositif de manutention destiné à mettre en place et à retirer les nacelles du dispositif de dépôt selon la revendication 9, comportant au moins deux paires de bras (30) superposés verticalement, les bras (30) de chaque paire étant configurés pour venir se positionner sous les pattes de manutention (26), les bras (30) étant mobiles verticalement et horizontalement en éloignement et en rapprochement du porte-nacelle.

12. Dispositif de manutention selon la revendication précédente, dans lequel les bras (30) sont mobiles en rotation autour d'un axe vertical (Z1).

13. Installation de dépôt chimique en phase vapeur assisté par plasma sur une pluralité de substrats comportant le dispositif de dépôt selon l'une des revendications1 à 10, un générateur électrique connecté aux nacelles et un dispositif de manutention selon la revendication 11 ou 12.

14. Installation de dépôt selon la revendication 13, comportant une zone de chargement/déchargement (ZC) des substrats des nacelles, une zone de refroidissement (ZR) et dans laquelle la zone de chargement/déchargement (ZC), la zone de refroidissement (ZR) et le dispositif de dépôt sont disposés autour de l'axe vertical (Z1) du dispositif de manutention.

15. Installation de dépôt selon la revendication précédente en combinaison avec l'une des revendications 3 à 5, dans laquelle la zone de chargement/déchargement (ZC) et/ou la zone de refroidissement (ZR) comporte(nt) un support de nacelles comportant des traverses horizontales destinées à coopérer avec les pattes de connexion.
